(19)

Europäisches
Patentamt
European
Patent Office
Office européen
des brevets

(11) **EP 3 118 348 A1**

(12) **EUROPEAN PATENT APPLICATION**
published in accordance with Art. 153(4) EPC

(43) Date of publication:
**18.01.2017 Bulletin 2017/03**

(21) Application number: **15760786.2**

(22) Date of filing: **07.01.2015**

(51) Int Cl.:
*C23C 14/34* (2006.01)     *C04B 35/00* (2006.01)
*C23C 14/08* (2006.01)     *H01B 5/14* (2006.01)
*H01B 13/00* (2006.01)

(86) International application number:
**PCT/JP2015/050300**

(87) International publication number:
**WO 2015/136949 (17.09.2015 Gazette 2015/37)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **11.03.2014 JP 2014048045**

(71) Applicant: **Tosoh Corporation
Shunan-shi, Yamaguchi 746-8501 (JP)**

(72) Inventors:
• **KURAMOCHI Hideto
Ayase-shi
Kanagawa 252-1123 (JP)**
• **TAMANO Kimiaki
Ayase-shi
Kanagawa 252-1123 (JP)**
• **AKIIKE Ryo
Ayase-shi
Kanagawa 252-1123 (JP)**

(74) Representative: **TBK
Bavariaring 4-6
80336 München (DE)**

(54) **SINTERED OXIDE AND TRANSPARENT CONDUCTIVE OXIDE FILM**

(57)     The purpose of the present invention is to provide a sintered oxide capable of realizing a sufficiently low resistivity even in a production process for producing a film or a device wherein the maximum temperature is suppressed to be at a low temperature, and a transparent conductive oxide film obtainable therefrom. A sintered oxide having indium, zirconium, yttrium, hafnium and oxygen as constituent elements. The sintered oxide is characterized in that when the indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.

**EP 3 118 348 A1**

**Description**

TECHNICAL FIELD

The present invention relates to a sintered oxide, a sputtering target, and a transparent conductive oxide film and a method for its production.

BACKGROUND ART

A transparent conductive oxide film has a relatively high transmittance in the visible light region as well as a low resistance, and therefore, is used for electrodes of various light receiving devices such as solar cells or display devices such as liquid crystals, and further, it is utilized in various fields, e.g. as a heat reflecting film or antistatic film for automobiles or buildings, or as a transparent heating material for antifogging, for freezing showcases, etc. Among them, an indium oxide film having tin added, is widely utilized as an ITO (Indium Tin Oxide) film.

In recent years, it has become very important to improve electric characteristics and optical characteristics, as demanded, in order to maximize device characteristics, and active developments have been made especially in applications for e.g. electrodes of various light receiving devices such as solar cells or display devices such as liquid crystals.

In the above-mentioned ITO film, it has been attempted to adjust electrical characteristics and optical characteristics by adjusting the addition amount of tin. However, in this method, it has been difficult to improve both electrical characteristics such as resistance, and optical characteristics such as transmittance and optical absorptivity, at the same time. For example, in Non-Patent Document 1, the dependency on the $Sn_2O_3$ amount, of the electro-optical characteristics, is disclosed with respect to an $In_2O_2$-$SnO_2$ type transparent conductive film. According to this, in the $In_2O_3$-$SnO_2$ type transparent conductive film, the resistance becomes lowest when the $SnO_2$ amount is at a level of about 10 wt%. However, in such a $SnO_2$ amount, the plasma wavelength tends to shift to the shorter wavelength side, whereby in the infrared region, absorptivity tends to be large, and transmittance tends to decrease.

A transparent conductive oxide film is used in a suitable thickness depending on the application. For example, when used for e.g. electrodes of various light receiving devices such as solar cells, a transparent conductive oxide film having a film thickness of from about 100 nm to 300 nm is used in many cases. In applications for display devices such as liquid crystals, particularly for touch panels, in addition to a glass substrate, a flexible substrate using a polymer film is employed in many cases. In such a case, it is used in the form of a very thin film with a film thickness at a level of from about 5 to 50 nm.

Further, in recent years, in various devices, a polymer film or an organic material is often incorporated in the device structure, and therefore, it is required to suppress the maximum temperature in the process for producing a film or device to be at a low temperature.

Under these circumstances, there have been attempts to improve a sputtering target and a film thereby obtainable, to have desired properties, by addition of an element to indium oxide.

Patent Documents 1 and 2 disclose a sintered oxide composed of indium, at least one element among metal elements including zirconium, yttrium and hafnium, and oxygen. However, disclosed in each of Patent Documents 1 and 2, is only one having the above single metal element added alone.

Patent Documents 3 and 4 disclose a sputtering target having an insulating oxide contained in indium oxide, and, as the insulating oxide, zirconium oxide and hafnium oxide are mentioned. However, in each of the documents, there is no description at all about Examples in which zirconium oxide or hafnium oxide is added.

PRIOR ART DOCUMENTS

PATENT DOCUMENTS

Patent Document 1: JP-A-H9-209134
Patent Document 2: JP-A-H9-150477
Patent Document 3: JP-A-2003-105532
Patent Document 4: JP-A-2004-149883

NON-PATENT DOCUMENT

Non-Patent Document 1: TOSOH Research & Technology Review, 47, pp. 11-20 (2003)

DISCLOSURE OF INVENTION

TECHNICAL PROBLEM

In applications where optical properties are of importance, including e.g. electrodes of various light receiving devices such as solar cells and display devices such as liquid crystals, a polymer film or an organic material is often incorporated in the device structure, and therefore, it is required to suppress the maximum temperature of the process for producing a film or device to be at a low temperature.
Accordingly, it is an object of the present invention to provide a sintered oxide capable of realizing a sufficiently low resistivity even by a process for producing a film or device wherein the maximum temperature of the process is suppressed to be at a low temperature, and a transparent conductive oxide film obtainable therefrom.
Further, it is an object of the present invention to provide a transparent conductive oxide film excellent in durability in a high temperature and high humidity environment and a sintered oxide for obtaining it.

SOLUTION TO PROBLEM

In view of such background, the present inventors have conducted intensive studies. As a result, they have found that by adding specific elements at specific ratios to indium oxide, it possible to obtain a sintered oxide capable of forming a transparent conductive oxide film realizing a sufficiently low resistance by a process for producing a film or device wherein the maximum temperature of the process is suppressed to be at a low temperature, and thus have arrived at accomplishing the present invention.
Further, the present inventors have found it possible to obtain a sintered oxide capable of forming a transparent conductive oxide film excellent in durability in a high temperature and high humidity environment, and thus have arrived at accomplishing the present invention.
The present invention provides a sintered oxide characterized in that when the indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.
Further, the present invention provides a sputtering target characterized by comprising the above sintered oxide.
Further, the present invention provides a method for producing a transparent conductive oxide film, characterized by sputtering using the above sputtering target.
Further, the present invention provides a transparent conductive oxide film wherein when indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.
Further, the above transparent conductive oxide film comprises a composite oxide having indium, zirconium, yttrium, hafnium and oxygen, as constituent elements.
Further, the above transparent conductive oxide film is characterized by having a film thickness of from 5 to 50 nm and a resistivity of at most 200 Q/□.
Further, the present invention provides a laminated substrate containing a transparent conductive oxide film, characterized in that it is constituted by the above transparent conductive oxide film and a substrate.
Further, the present invention provides a device using the above laminated substrate.
Further, the present invention provides an electronic equipment using the above device.

ADVANTAGEOUS EFFECTS OF INVENTION

The sintered oxide of the present invention can be used as a sputtering target. And, by sputtering using the sputtering target, it is possible to produce a transparent conductive oxide film of the present invention, while suppressing abnormal discharge during the sputtering.
The transparent conductive oxide film of the present invention can realize a sufficiently low resistance by a process for producing a film or device wherein the maximum temperature of the process is suppressed to be at a low temperature, and it can be suitably used for devices and electronic equipments.
Further, for example, by using it for a solar cell, it is possible to reduce an optical loss or heat generation due to optical absorption, than a conventional solar cell. It is thereby possible to provide a solar cell whereby the photoelectric conversion efficiency is high and stable. Here, the solar cell means a solar cell using a transparent conductive oxide film. As such a solar cell, a silicon-type solar cell using monocrystalline silicon, polycrystalline silicon or amorphous silicon, a compound-type solar cell using e.g. $CuInSe_2$, $Cu(In, Ga)Se_2$, GaAs or CdTe, and a dye-sensitizing solar cell, may be exemplified.
Further, the transparent conductive oxide film of the present invention is excellent in durability in a high temperature and high humidity environment, and can be suitably used as a highly reliable material in various applications.

DESCRIPTION OF EMBODIMENTS

Now, preferred embodiments of the present invention will be described in detail.

The sintered oxide of this embodiment is characterized in that when indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%. In this specification, "at%" means "atomic%". That is, in the sintered oxide of this embodiment, the atomic ratio (the ratio in the number of atoms) of Zr to the sum of In, Zr, Y and Hf, is from 0.1 to 3.0 at%, the atomic ratio (the ratio in the number of atoms) of Y to the sum of In, Zr, Y and Hf, is from 0.005 to 0.5 at%, and the atomic ratio (the ratio in the number of atoms) of Hf to the sum of In, Zr, Y and Hf is from 0.0002 to 0.15 at%.

In such a composition range, it is possible to form a transparent conductive oxide film that can realize a sufficiently low resistance by a process for producing a film or device wherein the maximum temperature of the process is suppressed to be at a low temperature. From the viewpoint of further reducing the resistance of the transparent conductive oxide film, the lower limit of Zr/(In+Zr+Y+Hf) is preferably 0.3 at%. From the same viewpoint, the upper limit of Zr/(In+Zr+Y+Hf) is preferably 2.7 at%.

From the viewpoint of further reducing the resistance of the transparent conductive oxide film, the lower limit of Y/(In+Zr+Y+Hf) is preferably 0.01 at%. From the same viewpoint, the upper limit of Y/(In+Zr+Y+Hf) is preferably 0.25 at%.

From the viewpoint of further reducing the resistance of the transparent conductive oxide film, the lower limit of Hf/(In+Zr+Y) is preferably 0.001 at%. From the same viewpoint, the upper limit of Hf/(In+Zr+Y) is preferably 0.08 at%.

In this embodiment, from the viewpoint of realizing a low resistivity of the transparent conductive oxide film at a higher level, Zr/(In+Zr+Y+Hf) is from 0.3 to 2.7 at%. Further, Y/(In+Zr+Y+Hf) is from 0.01 to 0.25 at%. Further, Hf/(In+Zr+Y) is from 0.001 to 0.08 at%.

The sintered oxide of the present invention contains a composite oxide having indium, zirconium, yttrium, hafnium and oxygen, as constituent elements. The content of indium in the sintered oxide, to the total of the metallic elements, is preferably at least 95 at%, more preferably at least 96 at%, more preferably from 97 to 99.8 at%.

The sintered oxide and the transparent conductive oxide film in this embodiment may contain an unavoidable very small amount of impurities. As such impurities, compounds such as oxides having metal elements other than In, Zr, Y and Hf, may be mentioned. The total content of such impurities in the sintered oxide, is, as calculated as metal elements, preferably at most 1 at%, more preferably at most 0.5 at%, further preferably at most 0.1 at%, particularly preferably at most 0.01 at%, to the sum of In, Zr, Y and Hf.

The relative density of the sintered oxide in this embodiment is preferably at least 97%, more preferably at least 99%. When a sintered oxide having such a relative density is used as a sputtering target, it is possible to further reduce abnormal discharge during the sputtering.

The relative density in this specification is calculated as follows. That is, In, Zr, Y and Hf are calculated as oxides i.e. $In_2O_3$, $ZrO_2$, $Y_2O_3$ and $HfO_2$ respectively, to obtain their weight ratios. Here, the obtained weight ratios of $In_2O_3$, $ZrO_2$, $Y_2O_3$ and $HfO_2$ are, respectively, represented by a (%), b (%),c (%) and d (%). Here, a, b, c and d can be obtained from the raw material composition, i.e. the ratio of charged amounts of the respective oxide powders in the mixed powder for molding at the time of producing the sintered oxide.

Then, the true densities of the respective oxides are assumed to be $In_2O_3$: 7.18 g/cm$^3$ , $ZrO_2$: 6.00 g/cm$^3$ , $Y_2O_3$: 5.01 g/cm$^3$ and $HfO_2$ 9.68 g/cm$^3$. Using the values of these true densities, the theoretical density A (g/cm) is calculated by the following formula.

$$A = (a + b + c + d)/((a/7.18) + (b/6.00) + (c/5.01) + (d/9.68))$$

On the other hand, the sintered density B (g/cm$^3$) of the sintered oxide is measured by the Archimedes' method in accordance with JIS-R1634-1998.

The relative density (%) is obtained by the following formula, as a relative value of the sintered density B (g/cm$^3$) to the arithmetically calculated theoretical density A (g/cm$^3$).

$$Relative\ Density\ (\%) = (B/A) \times 100.$$

The upper limit for the average particle size of particles constituting the sintered oxide in this embodiment is preferably at most 10 μm, more preferably at most 6 μm. With such an average particle size, it is possible to increase the strength of the sintered oxide. The lower limit for the average particle size is, in view of ease of production, preferably

0.01 $\mu$m, more preferably 0.5 $\mu$m, further preferably 2 $\mu$m.

In this specification, the average particle size of particles contained in the sintered oxide, is measured by the following procedure. That is, the sintered oxide of the present invention is cut into a suitable size, and then, the surface to be observed, is polished. Then, to this polished surface, chemical etching is applied with a dilute hydrochloric acid solution, to clarify the grain boundary. The etched surface of the sintered oxide is observed means of EPMA, SEM/EDS or XRD, etc., and an observation photograph is taken. The major axes of 500 or more particles contained in the observation photograph are measured by image processing. An arithmetic mean value of the major axes measured in this manner, is adopted as the average particle size.

Next, a preferred embodiment of the method for producing the sintered oxide will be described.

The production method in this embodiment comprises a mixing step of preparing a mixed powder for molding which contains a powder of the indium source, a powder of the zirconium source, a powder of the yttrium source and a powder of the hafnium source, a molding step of molding the mixed powder to prepare a molded product, and a firing step of firing the molded product to obtain a sintered oxide. Now, the respective steps will be described in detail as follows.

In the mixing step, a mixed powder containing oxides of indium, zirconium, yttrium and hafnium, is prepared. In this embodiment, the method for mixing the raw material powders is not particularly limited, and the powder of the indium source, the powder of the zirconium source, the powder of the yttrium source and the powder of the hafnium source may be mixed simultaneously, or some may be pre-mixed and then, the rest may be added and mixed.

As the mixing method, it is preferred that firstly, a powder of the zirconium source, a powder of the yttrium source and a powder of the hafnium source are premixed and calcined. The raw material powders are not limited, but in consideration of the handling efficiency, zirconium oxide powder, yttrium oxide powder and hafnium oxide powder are preferred.

Instead of zirconium oxide powder, yttrium oxide powder and hafnium oxide powder, compounds which may be converted by firing to zirconium oxide, yttrium oxide and hafnium oxide, may be used. As such compounds, metal salts such nitrates, chlorides or carbonates, or alkoxides, of zirconium, yttrium and hafnium, may be mentioned. The average primary particle sizes of raw material powders, are, from the viewpoint of handling efficiency, preferably at most 1.5 $\mu$m, more preferably from 0.1 to 1.5 $\mu$m. By using such powders, it is possible to further increase the density of the sintered oxide.

Here, when the premixing is carried out, the method is not particularly limited, and mixing methods including dry and wet media stirring-type mill using balls or beads of zirconia, alumina, nylon resin, etc., and media-less container rotary mixing, as well as mechanical stirring type mixing, etc., may be exemplified. Specifically, a ball mill, a bead mill, an attritor, a vibrating mill, a planetary mill, a jet mill, a V-shaped mixer, a paddle mixer, and a biaxial planetary stirring mixer, may, for example, be mentioned.

In the case of using a ball mill, bead mill, attritor, vibration mill, planetary mill or jet mill, of a wet type method, the slurry after milling is dried. The drying method is not particularly limited, but, for example, filtration and drying, fluidized bed drying, spray drying, etc. may be mentioned. Further, in the case of using a solution of metal salts, or a solution of alkoxides, as the raw material, it is preferred to dry precipitates precipitated from the solution.

In the case of conducting the preliminary mixing, the premixed powder obtained, is preferably calcined at from 800 to 1,200°C. The calcining temperature is more preferably from 1,000 to 1,200°C, and the time is sufficient, when it is from 1 to 3 hours. The calcined powder obtained is preferably subjected to disintegration treatment to bring the the average primary particle diameter to be at most 0.5 $\mu$m. The treating method for the disintegration, etc. is not particularly limited, but mixing methods of dry and wet media stirring type mill using balls or beads of zirconia, alumina, nylon resins, etc. may be mentioned. Specifically, a ball mill, a bead mill, an attritor, a vibrating mill, a planetary mill, and a jet mill may, for example, be mentioned. Here, in the case of using a ball mill, bead mill, attritor, vibration mill, planetary mill or jet mill, of a wet method, the slurry after disintegration is dried. The drying method is not particularly limited, but, for example, filtration and drying, fluidized bed drying, and spray drying, may, for example, be mentioned.

Then, so that the desired final composition is obtainable, indium oxide powder and the disintegrated calcined powder are mixed to obtain a mixed powder for molding. By using the indium oxide powder, it is possible to reduce cumbersomeness of the process or concomitant work such as powder treatment, etc. If the indium source is other than an oxide, for example, a nitrate, chloride, carbonate or the like, it is calcined and converted to the oxide and then used. The average primary particle sizes of these powders, are, in consideration of handling efficiency, preferably at most 1.5 $\mu$m, more preferably from 0.1 to 1.5 $\mu$m. By using the powders having such particle sizes, it is possible to further increase the density of the sintered oxide.

Here, the method for mixing the indium oxide powder and the calcined powder is not particularly limited, and mixing methods including dry and wet media stirring-type mill using balls or beads of zirconia, alumina, nylon resin, etc., media-less vessel rotation type mixing, and mechanical stirring type mixer may be exemplified. Specifically, a ball mill, a bead mill, an attritor, a vibrating mill, a planetary mill, a jet mill, a V-shaped mixer, a paddle mixer and a biaxial planetary stirring mixer, may, for example, be mentioned. Here, in the case of using a ball mill, bead mill, attritor, vibration mill, planetary mill or jet mill, of a wet type method, it is necessary to dry the slurry after milling. The drying method is not particularly limited, but, for example, filtration and drying, fluidized bed drying, and spray drying, may, for example, be mentioned.

The mixed powder for molding thus obtained, may be subjected to granulation treatment, etc. to improve the operation efficiency in the molding process. By such operations, it is possible to further improve the moldability and sinterability.

The amounts of a powder of the indium source, a powder of the zirconium source, a powder of the yttrium source and a powder of the hafnium source, to be used in the mixing step, are preferably within the following ranges, when the composition of the mixed powder for molding (final composition) is represented by atomic ratios of metal elements. That is, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.

Within such composition ranges, it is possible to form a transparent conductive oxide film that can realize more sufficiently low resistance by a process for producing a film or device wherein the maximum temperature of the process is suppressed to be at a low temperature. Further, it is possible to obtain a transparent conductive oxide film excellent in durability in a high temperature and high humidity environment.

In the molding step, the mixed powder for molding obtained in the mixing step, is molded. The molding method is not particularly limited, and it is possible to suitably select a molding method capable of molding the mixed powder into a desired shape. For example, a press molding method, a cast molding method, etc. may be exemplified. The molding pressure is not particularly limited and may be suitably set within a range where no cracking takes places, and it is possible to prepare a molded product that can be efficiently handled. The compacted density of the molded product is preferably as high as possible. For that purpose, it is also possible to use a method such as cold isostatic pressing (CIP). At that time, as the case requires, an organic additive to improve moldability may be added.

In the case of using an additive at the time of the molding, in order to remove moisture or the organic additive remaining in the molded product, it is preferred to carry out heat treatment at a temperature of from 80 to 500°C, prior to the firing step. This treatment temperature may be suitably selected depending on residual moisture, the amount and type of the additive, etc.

In the firing step, the molded product obtained in the molding step, is fired. The temperature-raising rate is not particularly limited and is preferably from 10 to 400°C/hr with a view to preventing cracking and shortening the firing time. The holding temperature for sintering (sintering holding temperature) is preferably at least 1,400°C and less than 1,650°C, more preferably at least 1,500°C and at most 1,625°C. Under such firing conditions, it is possible to obtain a sintered oxide with a higher density. The holding time is preferably at least 1 hour, more preferably from 3 to 10 hours. It is thereby possible to obtain a sintered oxide with a higher density and a small average particle size. The cooling rate is not particularly limited, so long as it is set within a usual range, and with a view to preventing cracking and shortening the firing time, it is preferably from 10 to 500°C/hr.

The atmosphere during the firing is preferably an atmosphere containing oxygen. It is preferred to carry out the firing in a stream of oxygen. It is particularly preferred to set the ratio of the weight of the molded product (charged amount, kg) to the oxygen flow rate (L/min) at the time of introducing oxygen into the furnace for sintering (weight of the molded product/oxygen flow rate) to be at most 1.0 [kg/(L/min)]. By doing so, it is possible to obtain a sintered oxide with a higher density.

The method for producing the sintered oxide of the present invention is not limited to the above-described method. For example, in the mixing step, without conducting the pre-mixing and calcination, a powder of the indium source, a powder of the zirconium source, a powder of the yttrium source and a powder of the hafnium source may be mixed together to prepare a mixed powder for molding.

The sputtering target of this embodiment is characterized by comprising the above sintered oxide. Such a sputtering target is excellent in discharge characteristics during the film deposition, and it is thereby possible to carry out the film deposition stably by suppressing abnormal discharge. This sputtering target has the same composition and structure as the sintered oxide.

In this embodiment, the sintered oxide may be used as it is, as a sputtering target, or the sintered oxide may be processed into a predetermined shape and then used as a sputtering target.

The surface roughness of the sputtering surface of the sputtering target is preferably at most 3 μm, more preferably at most 2 μm, by the center line average roughness (Ra). This makes it possible to further suppress the number of abnormal discharges during the film deposition, and it becomes possible to stably carry out the film deposition. The center line average roughness can be adjusted by e.g. a method of mechanically processing the surface of the sintered composite oxide that becomes a sputtering surface, by grinding wheels different in count, or a method of blast processing such as sandblasting. The center line average roughness can be obtained, for example, by evaluating the measurement surface by a surface state measuring device. Using the sputtering target of this embodiment, film deposition can be conducted by a sputtering method. As the sputtering method, a DC sputtering method, a RF sputtering method, an AC sputtering method, a DC magnetron sputtering method, a RF magnetron sputtering method or an ion beam sputtering method may be suitably selected for use. Among them, a DC magnetron sputtering and a RF magnetron sputtering method are preferred in that it is thereby possible to carry out film deposition uniformly in a large area and at a high speed.

The temperature at the time of sputtering is not particularly limited and is suitably set depending upon the heat resistance of the substrate used. For example, in a case where alkali-free glass is used as a substrate, it is usually preferably at most 250°C, and in a case where a resin film is used as a substrate, it is usually preferably at most 150°C. In a case where a substrate excellent in heat resistance, such as quartz, ceramics or metal, is used, it is possible to carry out film deposition at a temperature higher than these temperatures.

As the atmosphere gas at the time of sputtering, usually, an inert gas such as argon gas is used. If necessary, oxygen gas, nitrogen gas or hydrogen gas may, for example, be used.

The transparent conductive oxide film of this embodiment can be obtained by film deposition by sputtering using the above-described sputtering target. That is, the transparent conductive oxide film of this embodiment can be obtained by carrying out the step of forming a film by sputtering a sputtering target comprising the sintered oxide.

The transparent conductive oxide film of the present embodiment is able to realize a more sufficiently low resistance even by a process for producing a film or device wherein the maximum temperature of the process is suppressed to be at a low temperature of lower than 200°C, particularly lower than 180°C. Further, it is possible to obtain a transparent conductive oxide film excellent in durability in a high temperature and high humidity environment.

To the composition of the transparent conductive oxide film obtained by the above method, the composition of the target used for the sputtering is reflected. That is, by using a sputtering target composed of the above-described sintered oxide, it is possible to obtain a transparent conductive oxide film having a composition wherein Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.

That is, the transparent conductive oxide film in this embodiment has the same composition as the sputtering target and the sintered oxide.

Therefore, the transparent conductive oxide film contains an oxide having indium, zirconium, yttrium, hafnium and oxygen, as constituent elements. Preferred ranges of the content of indium, the content of zirconium, the content of yttrium and the content of hafnium in the transparent conductive oxide film, are the same as the sintered oxide.

From the viewpoint of realizing a sufficiently low resistance of the transparent conductive oxide film in this embodiment by a process for producing a film or device wherein the maximum temperature of the process is suppressed to be at a low temperature, the lower limit of Zr/(In+Zr+Y+Hf) is preferably 0.3 at%. From the same viewpoint, the upper limit of Zr/(In+Zr+Y+Hf) is preferably 2.7 at%.

From the viewpoint of further reducing the resistance of the transparent conductive oxide film in this embodiment, the lower limit of Y/(In+Zr+Y+Hf) is preferably 0.01 at%. From the same viewpoint, the upper limit of Y/(In+Zr+Y+Hf) is preferably 0.25 at%.

From the viewpoint of further reducing the resistance of the transparent conductive oxide film in this embodiment, the lower limit of Hf/(In+Zr+Y+Hf) is preferably 0.001 at%. From the same viewpoint, the upper limit of Hf/(In+Zr+Y+Hf) is preferably 0.08 at%.

In this embodiment, from the viewpoint of realizing a low resistivity of the transparent conductive oxide film at a higher level, Zr/(In+Zr+Y+Hf) is preferably from 0.3 to 2.7 at%. Further, Y/(In+Zr+Y+Hf) is preferably from 0.01 to 0.25 at%. Further, Hf/(In+Zr+Y+Hf) is preferably from 0.001 to 0.08 at%.

The transparent conductive oxide film is made to have a suitable thickness depending on the application. For example, when it is used for electrodes of various light receiving devices such as solar cells, for TFT and CF of display devices, for transparent electrodes of organic EL devices, etc. the transparent conductive oxide film having a film thickness of from about 100 nm to 300 nm is used in many cases. In applications to display devices such as liquid crystals, in particular to touch panels, in addition to a glass substrate, a flexible substrate using a polymer film may be employed in many cases. In such applications, it is used in the form of a very thin film having a film thickness of from about 5 to 50 nm. Further, in order to have a structure obtained by laminating a low heat-resistant material, or in order to use a polymer film, it is required to suppress the maximum temperature of the film deposition process to be at a low temperature.

The transparent conductive oxide film of the present invention can be suitably used as a laminated substrate comprising a substrate and the transparent conductive oxide film.

Here, the substrate may, for example, be a glass substrate including alkali-free glass, quartz, etc., a polymer film substrate made of a resin, or a substrate of ceramics or metal. In particular, in the case for a display device, visibility is very important, and therefore, a glass substrate comprising alkali-free glass, quartz or the like, or a polymer film substrate made of a resin, is preferred.

Such a laminated substrate is suitably used as a device combined with a plurality of functional components. For example, it is suitable for an optical device such as a solar cell or a display device such as FPD or a touch panel. In particular, the above-mentioned display device is suitably used as incorporated in an electronic equipment and is particularly suitable for a small-sized high-performance electronic equipment like a mobile device.

In the foregoing, preferred embodiments of the present invention have been described, but the present invention is not limited to the above-described embodiments.

EXAMPLES

The present invention will be described more specifically with reference to the following Examples, but the present invention is not limited to these Examples.

[Examples 1 to 11, Comparative Examples 1 to 10, Reference Examples 1 to 3]

<Preparation of sintered oxide>

As raw material powders, indium oxide powder having a purity of 99.99 wt% and an average particle size of 0.5 μm, zirconium oxide powder having a purity of 99.9 wt% and an average particle size of 0.2 μm, yttrium oxide powder having a purity of 99.9 wt% and an average particle size of 0.2 μm, and hafnium oxide powder having a purity of 99.99% and an average particle size 0.2 μm, were prepared. These raw material powders were weighed so that the atomic ratios would be as shown in Table 1, and mixed in a dry ball mill to obtain a mixed powder for molding. The average particle size of the mixed powder was 0.2 μm.

The mixed powder was molded by the following procedure to prepare a molded product. Firstly, by using a mold having a diameter of 150 mm, the mixed powder was molded under a pressure of 0.3 ton/cm$^2$. Then, by conducting CIP molding under a pressure of 3.0 ton/cm$^2$, a molded product of cylindrical shape was obtained. This molded product was placed in a sintering furnace adjusted to a pure oxygen atmosphere and sintered under the following conditions to prepare a sintered oxide of disc shape. In this manner, the sintered oxide in each of Examples and Comparative Examples was obtained. Here, the holding time is the time held at the firing temperature. The firing temperature is the holding temperature.

(Firing conditions)

- Temperature-raising rate: 50°C/hr
- Sintering holding temperature: 1,600°C
- Holding time: 5 hours
- Sintering atmosphere: Pure oxygen gas was introduced into the furnace from before initiation of the temperature-raising (at room temperature) until reaching 100°C during the cooling
- Cooling rate: 100°C/hr
- Weight of molded product/oxygen flow rate: 0.9 [kg/(L/min)].

<Evaluation of sintered oxide>

(Composition)

The composition of the sintered oxide in each of Examples, Comparative Examples and Reference Examples, was quantified by ICP emission spectrometry by means of a commercially available ICP emission spectrometer. And, the atomic ratios were obtained. The results are shown in Table 1. Here, the composition of the sintered oxide, was virtually identical to the composition of the mixed powder for molding.

(Relative Density)

The relative density of the sintered oxide in each of Examples, Comparative Examples and Reference Examples, was obtained. The relative density is a value obtained by the following formula when the theoretical density of the sintered oxide is represented by A, and the sintered density is represented by B. The methods for measuring theoretical density A and sintered density B are as described above. The measurement results are shown in Table 1.

$$\text{Relative Density (\%)} = (B/A) \times 100$$

(Average particle size)

The average particle size of particles constituting the sintered oxide in each of Examples and Comparative Examples, was measured. The method for measuring the average particle size is as described above. However, the observation photograph of the polished surface of the sintered oxide (magnification: 1,000 to 5,000 times) was taken by means of a scanning electron microscope. In this observation photograph, the major axes of 500 particles were obtained. The arithmetic mean value of the major axes obtained was adopted as the average particle size. The measurement results are shown in Table 1.

<Preparation of sputtering target and transparent conductive oxide film>

The sintered oxide prepared in each of Examples and Comparative Examples was processed into a disc shape (diameter: 4 inches = 101.6 mm). The surface to become a sputtering surface when used as a sputtering target, was polished by using a surface grinder and a diamond grinding wheel. By changing the count of the grinding wheel at the time of polishing, the center line average roughness (Ra) was adjusted. In such a manner, a sputtering target was prepared. Ra of the sputtering surface of the sputtering target prepared, was measured by means of a commercially available surface texture measuring device (device name, Surftest SV-3100, manufactured by Mitutoyo). The results are as shown in Table 1.

Using the obtained sputtering target, a film was formed on a substrate under the following conditions by a DC magnetron sputtering method. After the film deposition, post-treatment was conducted under the following conditions to obtain a transparent conductive oxide film.

(Film deposition conditions)

- Apparatus: DC magnetron sputtering apparatus
- Magnetic field intensity: 1,000 Gauss (just above target, the horizontal component)
- Substrate temperature: room temperature (25°C)
- Ultimate vacuum degree: $5 \times 10^{-4}$ Pa
- Atmosphere during film deposition: argon
- Gas pressure during sputtering: 0.5 Pa
- DC power: 200 W
- Film thickness: 20 nm
- Substrate used: alkali-free glass (EAGLE XG glass, manufactured by Corning, thickness: 0.7 mm)

(Post-processing conditions after film deposition)

After the film deposition, heat treatment was carried out for heating in the atmosphere at 170°C for 60 minutes. In this way, a sample having a transparent conductive oxide film formed on the substrate, was obtained. The following evaluations of the transparent conductive oxide film were carried out.

<Evaluations of transparent conductive oxide film>

(Light transmittance)

The light transmittance of a sample having the transparent conductive oxide film formed on the substrate, was measured by means of a spectrophotometer (trade name: U-4100, manufactured by Hitachi, Ltd.) within a wavelength range of from 240 nm to 2,600 nm, and an average value of the light transmittance within a wavelength range of from 400 to 800 nm which is important to a display device, was shown. The measurement results are shown in Table 1.

(Resistivity)

The resistivity of the transparent conductive oxide film was measured by means of a commercially available measuring apparatus (trade name: HL5500, manufactured by Nippon Bio-Rad Laboratories, Inc.). The measurement results are shown in Table 1.

(Durability)

A thin film sample was exposed in an environment at a temperature of 60°C under a relative humidity of 90% continuously for 1,000 hours, whereby the change in resistivity was observed. At that time, when the resistivities before and after the test were represented by A and B, respectively, B/A was obtained and used as an index for durability. Usually, this value tends to increase along with the test time and thus indicates that the smaller the value, the better the durability.

[Examples 12 to 16]

<Preparation of sintered oxide>

A sintered oxide was prepared in the same manner as in Example 1 except that the firing conditions were changed as shown in Table 2. In this manner, the sintered oxide in each of Examples 12 to 16 was obtained. Other firing conditions not shown in Table 2 were the same as those in Example 1.

<Preparation and evaluation of sputtering target and transparent conductive oxide film>

Using the sintered oxide obtained in each Example, a sputtering target was prepared, and a transparent conductive oxide film was obtained, in the same manner as in Example 1. Then, in the same manner as in Example 1, and the evaluations of the sintered oxide and the transparent conductive oxide film were conducted. The evaluation results are shown in Table 1.

[Reference Examples 4 to 6]

<Production of sintered oxide>

A sintered oxide was prepared in the same manner as in Example 1 except that as raw material powders, indium oxide powder, zirconium oxide powder having a purity of 99.9 wt% and an average particle size of 0.2 $\mu$m, yttrium oxide powder having a purity of 99.9 wt% and an average particle size of 0.2 $\mu$m, silicon oxide powder having a purity of 99.99 wt% and an average particle size of 0.5 $\mu$m, germanium oxide powder having a purity of 99.99 wt% and an average particle size of 0.4 $\mu$m, and bismuth oxide powder having a purity 99.9 wt% and an average particle size of 0.4 $\mu$m, were prepared, and mixed so that the atomic ratios would be as shown in Table 3. In this manner, the sintered oxide in each of Reference Examples 4 to 6 was obtained. Here, the relative density of the obtained sintered oxide was obtained by using the true densities of the respective oxides being $In_2O_3$: 7.18 g/cm$^3$, $ZrO_2$: 6.00 g/cm$^3$, $Y_2O_3$: 5.01 g/cm$^3$, $SiO_2$: 2.65 g/cm$^3$ , $GeO_2$: 6.2 g/cm$^3$ and $Bi_2O_3$: 8.76 g/cm$^3$ and calculating the theoretical density as described above.

<Preparation and evaluations of sputtering target and transparent conductive oxide film>

Using the sintered oxide obtained in each of Reference Examples 4 to 6, in the same manner as in Example 1, a sputtering target was prepared, and a transparent conductive oxide film was obtained. And, in the same manner as in Example 1, the evaluations of the sintered oxide and the transparent conductive oxide film were conducted. The evaluation results are shown in Table 3.

[Table 1]

| | Final composition of powder, and composition of sintered oxide (at%) | | | Relative density of sintered oxide (%) | Average particle size of sintered oxide (μm) | Ra of target | Deposition atmosphere (oxygen/ (argon+oxygen)) | Resistance (Ω/□) | Transmittance | Durability |
|---|---|---|---|---|---|---|---|---|---|---|
| | Zr/ (In+Zr+Y+Hf) | Y/ (In+Zr+Y+Hf) | Hf/ (In+Zr+Y+Hf) | | | | | | Wavelength 400-800 nm | 60°C 90%RH |
| Ex. 1 | 0.35 | 0.02 | 0.0002 | 99.2 | 6.5 | 0.42 | 0.00 | 182 | 90.2 | 1.09 |
| Ex. 2 | 0.75 | 0.05 | 0.001 | 99.2 | 6.5 | 0.42 | 0.00 | 180 | 90.0 | 1.07 |
| Ex. 3 | 1.30 | 0.04 | 0.02 | 99.2 | 6.5 | 0.42 | 0.00 | 152 | 90.0 | 1.07 |
| Ex. 4 | 1.40 | 0.10 | 0.0002 | 99.1 | 5.2 | 0.42 | 0.00 | 149 | 90.3 | 1.07 |
| Ex. 5 | 1.40 | 0.10 | 0.001 | 99.1 | 5.3 | 0.42 | 0.00 | 145 | 90.6 | 1.06 |
| Ex. 6 | 1.40 | 0.10 | 0.02 | 99.1 | 5.2 | 0.42 | 0.00 | 145 | 90.5 | 1.04 |
| Ex. 7 | 1.40 | 0.10 | 0.15 | 99.1 | 5.1 | 0.42 | 0.00 | 147 | 90.3 | 1.05 |
| Ex. 8 | 1.68 | 0.12 | 0.001 | 99.2 | 5.4 | 0.42 | 0.00 | 130 | 90.8 | 1.05 |
| Ex. 9 | 1.95 | 0.15 | 0.02 | 99.2 | 5.2 | 0.42 | 0.00 | 123 | 90.7 | 1.04 |
| Ex. 10 | 2.40 | 0.15 | 0.02 | 99.3 | 6.0 | 0.42 | 0.00 | 190 | 90.2 | 1.04 |
| Ex. 11 | 2.80 | 0.20 | 0.02 | 99.4 | 4.8 | 0.42 | 0.00 | 194 | 89.7 | 1.06 |
| Ex. 12 | 0.35 | 0.02 | 0.0002 | 99.3 | 8.8 | 0.42 | 0.00 | 182 | 90.2 | 1.09 |
| Ex. 13 | 0.35 | 0.02 | 0.0002 | 99.3 | 12.2 | 0.43 | 0.00 | 182 | 90.2 | 1.09 |
| Ex. 14 | 0.35 | 0.02 | 0.0002 | 99.3 | 16.4 | 0.44 | 0.00 | 182 | 90.2 | 1.09 |
| Ex. 15 | 0.35 | 0.02 | 0.0002 | 97.6 | 6.0 | 0.42 | 0.00 | 182 | 90.2 | 1.09 |
| Ex. 16 | 0.35 | 0.02 | 0.0002 | 93.8 | 3.4 | 0.41 | 0.00 | 182 | 90.2 | 1.09 |
| Comp. Ex. 1 | 0.00 | 0.00 | 0.00 | 99.0 | 8.2 | 0.42 | 0.00 | 260 | 88.0 | 2.15 |
| Comp. Ex. 2 | 0.02 | 0.002 | 0.00 | 99.1 | 7.0 | 0.42 | 0.00 | 230 | 88.1 | 1.97 |
| Comp. Ex. 3 | 0.02 | 0.20 | 0.00 | 99.1 | 7.0 | 0.42 | 0.00 | 258 | 88.4 | 1.55 |
| Comp. Ex. 4 | 0.02 | 0.55 | 0.00 | 99.1 | 7.2 | 0.42 | 0.00 | 268 | 88.4 | 1.41 |

| | Final composition of powder, and composition of sintered oxide (at%) | | | Relative density of sintered oxide (%) | Average particle size of sintered oxide (μm) | Ra of target | Deposition atmosphere (oxygen/ (argon+oxygen)) | Resistance (Ω/□) | Transmittance | Durability |
|---|---|---|---|---|---|---|---|---|---|---|
| | Zr/ (In+Zr+Y+Hf) | Y/ (In+Zr+Y+Hf) | Hf/ (In+Zr+Y+Hf) | | | | | | Wavelength 400-800 nm | 60°C 90%RH |
| Comp. Ex. 5 | 4.4 | 0.00 | 0.00 | 99.1 | 3.6 | 0.41 | 0.00 | 224 | 89.3 | 1.33 |
| Comp. Ex. 6 | 4.4 | 0.01 | 0.00 | 99.1 | 3.5 | 0.41 | 0.00 | 219 | 89.8 | 1.32 |
| Comp. Ex. 7 | 5.0 | 0.002 | 0.00 | 99.1 | 6.6 | 0.42 | 0.00 | 221 | 89.7 | 1.28 |
| Comp. Ex. 8 | 5.0 | 0.20 | 0.00 | 99.2 | 6.3 | 0.42 | 0.00 | 241 | 89.5 | 1.25 |
| Comp. Ex. 9 | 5.0 | 0.55 | 0.00 | 99.3 | 6.1 | 0.42 | 0.00 | 255 | 87.3 | 1.27 |
| Comp. Ex. 10 | 2.0 | 0.55 | 0.00 | 99.3 | 6.0 | 0.42 | 0.00 | 260 | 88.4 | 1.33 |
| Ref. Ex. 1 | 0.10 | 0.01 | 0.00 | 99.2 | 6.8 | 0.42 | 0.00 | 198 | 90.0 | 1.20 |
| Ref. Ex. 2 | 0.35 | 0.02 | 0.00 | 99.2 | 6.5 | 0.42 | 0.00 | 187 | 90.2 | 1.14 |
| Ref. Ex. 3 | 0.10 | 0.30 | 0.00 | 99.1 | 3.8 | 0.41 | 0.00 | 190 | 89.8 | 1.18 |
| Ex.: Example Comp. Ex.: Comparative Example, Ref. Ex.: Reference Example | | | | | | | | | | |

[Table 2]

|  | Firing temperature (°C) | Holding time (hr) |
|---|---|---|
| Example 12 | 1600 | 15 |
| Example 13 | 1600 | 25 |
| Example 14 | 1625 | 5 |
| Example 15 | 1550 | 25 |
| Example 16 | 1500 | 25 |

[Table 3]

| | Final composition of powder, and composition of sintered oxide (at%) | | | | Relative density of sintered oxide (%) | Average particle size of sintered oxide ($\mu$m) | Ra of target | Deposition atmosphere (oxygen/(argon+oxygen)) | Resistance ($\Omega/\square$) | Transmittance | Durability |
|---|---|---|---|---|---|---|---|---|---|---|---|
| | Zr/(In+Zr+Y+M) | Y/(In+Zr+Y+M) | M/(In+Zr+Y+M) | M | | | | | | Wavelength 400-800 nm | 60°C 90%RH |
| Ref. Ex. 4 | 1.40 | 0.10 | 0.15 | Si | 99.2 | 6.7 | 0.42 | 0.00 | 272 | 88.8 | 1.16 |
| Ref. Ex. 5 | 1.40 | 0.10 | 0.15 | Ge | 99.1 | 6.5 | 0.42 | 0.00 | 253 | 88.5 | 1.14 |
| Ref. Ex. 6 | 1.40 | 0.10 | 0.15 | Bi | 99.2 | 7.1 | 0.41 | 0.00 | 288 | 87.4 | 1.22 |

From the comparison between Examples 1 to 16 and Comparative Examples 1 to 10, it is evident that by a process for producing a film or device of a transparent conductive oxide film wherein the maximum temperature of the process is suppressed to be at a low temperature, in Examples 1 to 16, a sufficiently low resistance was realized, the transmittance was equal or higher, and the durability was high, as compared to Comparative Examples 1 to 10. Therefore, it was confirmed that better characteristics were shown in Examples 1 to 16 than in Comparative Examples 1 to 10. Further, from Reference Examples 1 to 3, it was confirmed that Example 1 to 16 had the effect of showing higher durability.

The entire disclosure of Japanese Patent Application No. 2014-048045 filed on March 11, 2014 including specification, claims and summary is incorporated herein by reference in its entirety.

INDUSTRIAL APPLICABILITY

According to the present invention, it is possible to provide a sputtering target, or a sintered oxide which is suitably used as a sputtering target. And, by sputtering using the sputtering target, it is possible to produce a transparent conductive oxide film while suppressing abnormal discharge during the sputtering. The transparent conductive oxide film of the present invention can realize a low resistance by a process for producing a film or device of a transparent conductive oxide film wherein the maximum temperature of the process is suppressed to be at a low temperature. Thus, for example, by using it in a solar cell, it is possible to suppress an optical loss and heat generation by light absorption, more than ever. Further, when prepared by a low temperature film deposition process, the transparent conductive oxide film of the present invention has a low resistivity and high transmittance, and therefore, it is useful, for example, not only for an application to a glass substrate, but also for an application to a touch panel employing a flexible substrate such as a film. Further, the transparent conductive oxide film of the present invention has high durability and thus can be suitably used for applications to various devices.

**Claims**

1. A sintered oxide having indium, zirconium, yttrium, hafnium and oxygen as constituent elements, **characterized in that** when the indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.005 to 0.5 at%, and Hf/(In+Zr+Y+Hf) is from 0.0002 to 0.15 at%.

2. A sputtering target comprising the sintered oxide as defined in Claim 1.

3. A method for producing a transparent conductive oxide film, which comprises a step of sputtering using the sputtering target as defined in Claim 2.

4. A transparent conductive oxide film wherein when indium, zirconium, yttrium and hafnium are represented by In, Zr, Y and Hf, respectively, in atomic ratios, Zr/(In+Zr+Y+Hf) is from 0.1 to 3.0 at%, Y/(In+Zr+Y+Hf) is from 0.01 to 0.5 at%, and Hf/(In+Zr+Y+Hf) is from 0.0002 to 0.15 at%.

5. The transparent conductive oxide film according to Claim 4, which comprises a composite oxide having indium, zirconium, yttrium, hafnium and oxygen as constituent elements.

6. The transparent conductive oxide film according to Claim 4 or 5, which has a film thickness of from 5 to 50 nm and a resistivity of at most 200 $\Omega/\square$.

7. A laminated substrate containing a transparent conductive oxide film, **characterized in that** it is constituted by the transparent conductive oxide film as defined in any one of Claims 4 to 6, and a substrate.

8. A device **characterized by** using the laminated substrate as defined in Claim 7.

9. An electronic equipment **characterized by** using the device as defined in Claim 8.

## INTERNATIONAL SEARCH REPORT

| | International application No. |
|---|---|
| | PCT/JP2015/050300 |

A. CLASSIFICATION OF SUBJECT MATTER
*C23C14/34*(2006.01)i, *C04B35/00*(2006.01)i, *C23C14/08*(2006.01)i, *H01B5/14*(2006.01)i, *H01B13/00*(2006.01)i

According to International Patent Classification (IPC) or to both national classification and IPC

B. FIELDS SEARCHED

Minimum documentation searched (classification system followed by classification symbols)
C23C14/34, C04B35/00, C23C14/08, H01B5/14, H01B13/00

Documentation searched other than minimum documentation to the extent that such documents are included in the fields searched
Jitsuyo Shinan Koho        1922-1996   Jitsuyo Shinan Toroku Koho   1996-2015
Kokai Jitsuyo Shinan Koho  1971-2015   Toroku Jitsuyo Shinan Koho   1994-2015

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2013-139380 A  (Tosoh Corp.), 18 July 2013 (18.07.2013), paragraphs [0018] to [0029], [0056] to [0061], [0083] to [0089] & US 2014/0332735 A1    & EP 2789595 A1 & WO 2013/084795 A1    & TW 201336801 A & CN 103987678 A     & KR 10-2014-0103097 A | 1-9 |
| Y | Seihin Anzen Data Sheet [online], The Nilaco Corporation, 22 August 2008 (22.08.2008), [retrieval date 10 March 2015 (10.03.2015)], Internet <URL: http://nilaco.jp/pdf/PURE.000116.pdf> | 1-9 |

| ☒ Further documents are listed in the continuation of Box C. | ☐ See patent family annex. |
|---|---|

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 11 March 2015 (11.03.15) | 24 March 2015 (24.03.15) |

| Name and mailing address of the ISA/ Japan Patent Office 3-4-3,Kasumigaseki,Chiyoda-ku, Tokyo 100-8915,Japan | Authorized officer |
|---|---|
| | Telephone No. |

Form PCT/ISA/210 (second sheet) (July 2009)

**INTERNATIONAL SEARCH REPORT**

International application No.

PCT/JP2015/050300

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2014/024986 A1  (Tosoh Corp.), 13 February 2014 (13.02.2014), paragraphs [0017], [0018] & JP 2014-194066 A | 1-9 |
| A | JP 05-070942 A  (Mitsubishi Materials Corp.), 23 March 1993 (23.03.1993), paragraphs [0011] to [0015] (Family: none) | 1-9 |
| A | JP 2005-194594 A  (Tosoh Corp.), 21 July 2005 (21.07.2005), paragraph [0045] (Family: none) | 1-9 |
| A | JP 2003-105532 A  (Mitsui Mining & Smelting Co., Ltd.), 09 April 2003 (09.04.2003), paragraphs [0008] to [0011] & TW 570909 B           & CN 1397661 A & KR 10-0744017 B1 | 1-9 |
| A | JP 09-209134 A  (Idemitsu Kosan Co., Ltd.), 12 August 1997 (12.08.1997), paragraphs [0015] to [0025] (Family: none) | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H9209134 A
- JP H9150477 A
- JP 2003105532 A
- JP 2004149883 A
- JP 2014048045 A

**Non-patent literature cited in the description**

- *TOSOH Research & Technology Review,* 2003, vol. 47, 11-20